Europäisches Patentamt

European Patent Office

Office européen des brevets

(19)

(11) EP 0 478 030 B1

(12) **EUROPÄISCHE PATENTSCHRIFT**

(45) Veröffentlichungstag und Bekanntmachung des Hinweises auf die Patenterteilung:
**26.06.1996 Patentblatt 1996/26**

(51) Int Cl.[6]: **G01R 33/46**

(21) Anmeldenummer: **91202150.8**

(22) Anmeldetag: **22.08.1991**

(54) **Verfahren für die zweidimensionale Kernresonanzspektroskopie**

Method for two dimensional NMR spectroscopy

Procédé pour la spectroscopie RMN à deux dimensions

(84) Benannte Vertragsstaaten:
**DE FR GB NL**

(30) Priorität: **29.08.1990 DE 4027252**

(43) Veröffentlichungstag der Anmeldung:
**01.04.1992 Patentblatt 1992/14**

(73) Patentinhaber:
• **Philips Patentverwaltung GmbH**
**22335 Hamburg (DE)**
Benannte Vertragsstaaten:
**DE**
• **Philips Electronics N.V.**
**5621 BA Eindhoven (NL)**
Benannte Vertragsstaaten:
**FR GB NL**

(72) Erfinder:
• **McKinnon, Graeme, Dr.**
**CH-8053 Zürich (CH)**

• **Bösiger, Peter, Dr.**
**CH-5400 Ennetbaden (CH)**

(74) Vertreter: **Hartmann, Heinrich, Dipl.-Ing. et al**
**Philips Patentverwaltung GmbH,**
**Röntgenstrasse 24**
**D-22335 Hamburg (DE)**

(56) Entgegenhaltungen:
**EP-A- 0 261 743**          **EP-A- 0 302 550**
**EP-A- 0 393 745**

• **MAGNETIC RESONANCE IN MEDICINE, vol. 6, no. 3, März 1988, DULUTH, MN, US, Seiten 334-343; G.C. McKinnon et al.: "Localized Double-Quantum Filter and Correlation Spectroscopy Experiments"**

## Beschreibung

Die Erfindung betrifft ein Verfahren für die zweidimensionale Kernspinresonanz-Korrelationsspektroskopie mit einer vier Impulse enthaltenden, vielfach wiederholten und zusammen mit einem homogenen stationären Magnetfeld auf einen Untersuchungsbereich einwirkenden Sequenz, die zwei 180°-Impulse enthält, in deren Mitte sich ein dritter, sogenannter Kohärenz-Transfer- Impuls befindet und denen ein erster Impuls vorangeht, dessen Abstand vom zweiten Impuls, der gleich oder größer ist als der Abstand der anderen Impulse voneinander, bei der Wiederholung der Sequenz variiert wird.

Ein derartiges Verfahren ist unter der Bezeichnung "Super-COSY" bekannt und u.a. in dem Buch von Chandrakumar/Subramanian "Modern Techniques in High-Resolution FT-NMR", Springer Verlag, Seiten 177-181 bekannt. Gemäß Fig. 4.41 dieser Veröffentlichung sind der erste und der dritte Impuls 90°-Impulse, die ebenso wie die beiden 180°-Impulse phasenkohärent sind, d.h. während dieser Impulse hat die Trägerschwingung des Hochfrequenzmagnetfeldes eine definierte Phasenlage. Das Kernresonanzsignal, das sich nach einem Zeitpunkt entwickelt, der von dem zweiten 180°-Impuls den gleichen zeitlichen Abstand aufweist, den dieser von dem dritten Impuls hat, wird in den Niederfrequenzbereich transponiert, digitalisiert und gespeichert. Bei den weiteren Wiederholungen dieser Sequenz wird der Abstand zwischen dem ersten Hochfrequenzimpuls und dem ersten 180°-Impuls variiert.

Die dabei entstehenden Kernresonanzsignale bilden einen zweidimensionalen Datensatz, dessen Daten einerseits von dem zeitlichen Abstand des betreffenden Abtastwertes vom zweiten 180°-Impuls und andererseits vom zeitlichen Abstand der beiden ersten Hochfrequenzimpulse abhängen. Führt man über jede dieser Variablen - jeweils vermindert um den Abstand des dritten Impulses von einem der beiden 180°-Impulse - eine Fouriertransformation durch, ergibt sich ein zweidimensionales Spektrum, in dem die Frequenzlinien zweier miteinander gekoppelter Molekülgruppen einerseits auf einer Diagonallinie erscheinen (diagonal-peaks) und andererseits symmetrisch zu dieser Diagonale (cross-peaks).

Mit diesen Verfahren lassen sich verschiedene der auch im menschlichen Körper vorkommenden Aminosäuren, wie z.B. die Glutamate, Glutamin, Taurine und die Inosite in geringer Konzentration nachweisen - allerdings nur in vitro. Bei in vivo Untersuchungen am menschlichen Körper ergeben sich zusätzliche Schwierigkeiten, weil in der Regel nur das Spektrum eines Teilvolumens des Untersuchungsbereiches interessiert (lokalisierte Spektroskopie) und weil darüberhinaus im Untersuchungsbereich an Wasser gebundene Protonen vorhanden sind, deren Konzentration mehrere Zehnerpotenzen höher ist als die Konzentration der Protonen in den gesuchten Aminosäuren.

Aus der Zeitschrift "Magnetic Resonance in Medicine", 6, Seiten 334-343 (1988) ist bereits ein Verfahren für die lokalisierte Korrelationsspektroskopie (COSY) bekannt, bei dem in einer Sequenz nach zwei 90°-Impulsen, deren Abstand variiert wird, im festen Abstand zum zweiten Impuls drei 180°-Impulse erzeugt werden, die von magnetischen Gradientenfeldern begleitet werden, deren Gradienten senkrecht zueinander verlaufen. Dabei wird das Echosignal verarbeitet. Nachteilig an diesem "Anhängen" der drei schichtselektiven 180°-Impulse an die eigentliche COSY-Sequenz ist, daß die Zeit vom ersten Anregungsimpuls bis zum Abtasten des Kernresonanzsignals wesentlich vergrößert wird, so daß dessen Amplitude infolge u.a. von Relaxationseffekten erheblich reduziert wird. Insbesondere kann das Verfahren nicht für eine Protonenspektroskopie in vivo benutzt werden, weil die Wasserunterdrückung nicht ausreicht.

Es ist Aufgabe der vorliegenden Erfindung, das eingangs genannte Verfahren so auszubilden, daß es für in vivo Untersuchungen benutzt werden kann. Diese Aufgabe wird erfindungsgemäß dadurch gelöst, daß während drei der vier Impulse magnetische Gradientenfelder wirksam sind, deren Gradienten zueinander senkrecht verlaufen, und daß vor und nach dem dritten Hochfrequenzimpuls ein magnetisches Gradientenfeld mit solcher Dauer und solchem Gradienten wirksam ist, daß das zeitliche Integral über diesen Gradienten vor dem dritten Impuls dem Betrage nach die gleiche Größe hat wie nach dem dritten Impuls.

Bei der Erfindung werden also drei der vier Hochfrequenzimpulse von magnetischen Gradientenfeldern mit zueinanderander senkrechten Gradienten begleitet. Dadurch ergibt sich für diese drei schichtselektiven Impulse eine ortsabhängige Phasenlage, so daß jede Phasenkohärenz zerstört wird. Die Erfindung basiert nämlich auf der Erkenntnis, daß eine solche Phasenkohärenz bei dem Super-COSY-Verfahren nicht erforderlich ist.

Für Komponenten, deren Kernmagnetisierung bereits durch den ersten Impuls sowie den darauffolgenden 180°-Impuls beeinflußt worden ist, ist das magnetische Gradientenfeld vor und nach dem dritten Impuls praktisch unwirksam; zu diesen Komponenten zählen u.a. die nachzuweisenden Aminosäuren. Die Komponenten hingegen, deren Kernmagnetisierung durch den notwendigerweise breitbandigen dritten Impuls zum erstenmal angeregt wird - und dazu gehören bei geeigneter Gestaltung des Verfahrens die an Wasser gebundenen Protonen - ist nur das magnetische Gradientenfeld nach diesem Impuls wirksam, so daß sie dadurch dephasiert werden und ihr Beitrag zum resultierenden Kernresonanzsignal verschwindet.

Eine bevorzugte Weiterbildung der Erfindung sieht vor, daß der erste Hochfrequenzimpuls ein frequenzselektiver, nicht von einem Gradientenfeld begleiteter Impuls ist, der die Kernmagnetisierung der an Wasser gebundenen Protonen nicht anregt, jedoch die Kernmagnetisierung der an die nachzuweisenden Verbindungen gebundenen Protonen, und daß vor, während und nach dem dritten Hochfrequenzimpuls wenigstens ein magnetisches Gradientenfeld mit solchem Gradienten und solcher Dauer wirksam ist, daß das zeitliche Integral über diesen Gradienten in dem in der Mitte des dritten Impulses endenden Zeitintervall genauso groß ist wie in dem in der Mitte des dritten Impuls beginnenden Zeitintervall. Hierbei wird die Kernmagnetisierung der an Wasser gebundenen Protonen weder durch den ersten Impuls noch durch den darauffolgenden 180°-Impuls angeregt, so daß sich in Verbindung mit den Gradientenfeldern vor und nach dem dritten Impuls insgesamt eine Wasserunterdrückung ergibt.

In weiterer Ausgestaltung der Erfindung ist vorgesehen, daß vor und nach den beiden 180°-Hochfrequenzimpulsen jeweils ein magnetisches Gradientenfeld mit solchem Gradienten und solcher Dauer wirksam ist, daß das zeitliche Integral über dieses Feld vor und nach den betreffenden Impulsen jeweils gleich groß ist. Durch die vor und nach den beiden 180°-Impulsen wirksamen Gradientenfelder wird einerseits die gesamte Kernmagnetisierung außerhalb des selektierten Teilvolumens (zusätzlich) dephasiert und andererseits die Kernmagnetisierung, die durch diese beiden Impulse angeregt werden kann, wenn deren sogenannter Flipwinkel nicht genau 180° beträgt.

Eine Kernspinresonanz-Anordnung zur Durchführung des Verfahrens, die ausgeht von Mitteln zur Erzeugung eines homogenen, stationären Magnetfeldes, mit einer Hochfrequenzspulenanordnung zum Erzeugen von Hochfrequenzimpulsen und zum Aufnehmen der als Reaktion darauf im Untersuchungsbereich erzeugten Kernspinresonanzsignale, mit einer Verarbeitungseinheit zum Erzeugen eines Spektrums aus den aufgenommenen Kernspinresonanzsignalen, mit einer Gradientenspulenanordnung zur Erzeugung magnetischer Gradientenfelder und mit einer Steuereinheit zum Steuern der Hochfrequenzspulenanordnung und der Gradientenspulenanordnung, ist dadurch gekennzeichnet, daß die Steuereinheit so ausgebildet ist, daß sie während drei der vier Hochfrequenzimpulse der Sequenz magnetische Gradientenfelder erzeugt, deren Gradienten zueinander senkrecht verlaufen, und daß vor und nach dem dritten Hochfrequenzimpuls ein magnetisches Gradientenfeld mit solcher Dauer und solchem Gradienten wirksam wird, daß das zeitliche Integral über dieses Feld vor dem dritten Impuls dem Betrage nach die gleiche Größe hat wie nach dem dritten Impuls.

Die Erfindung wird nachstehend anhand der Zeichnung näher erläutert: Es zeigen

Fig. 1 ein Gerät für medizinische Kernresonanuntersuchungen, mit dem das erfindungsgemäße Verfahren durchführbar ist,

Fig. 2 ein Blockschaltbild eines solchen Gerätes,

Fig. 3 die zeitliche Lage der Hochfrequenzimpulse und der magnetischen Gradientenfelder bei einer ersten Ausführungsform einer erfindungsgemäßen Sequenz und

Fig. 4 den zeitlichen Verlauf bei einer zweiten bevorzugten Ausführungsform.

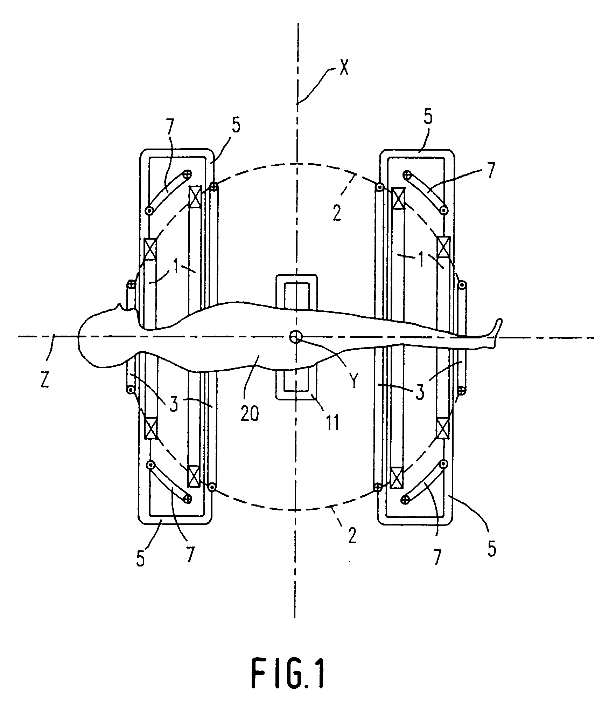

Das in Figur 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Figur 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an eine Sequenz dient die Hochfrequenzspule 11 oder eine gesonderte Hochfrequenz-Empfangsspule zum Empfangen der im Untersuchungsbereich erzeugten Kernresonanzsignale.

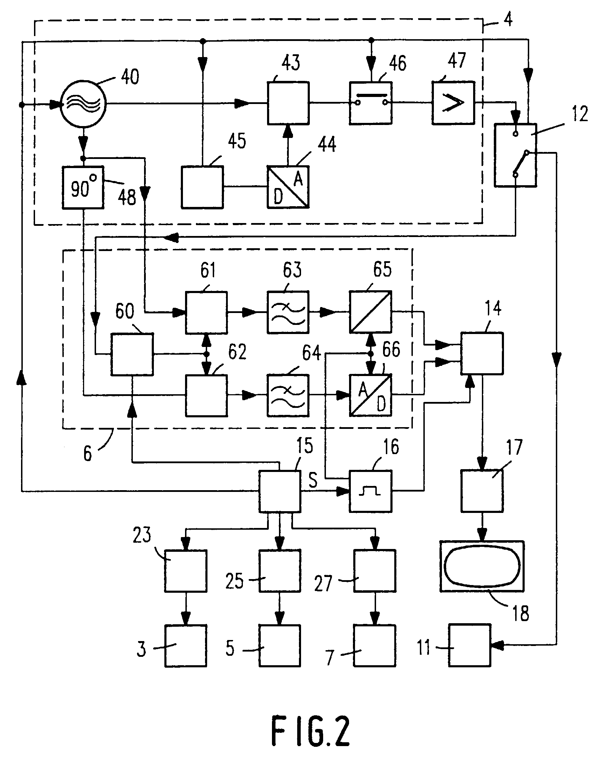

Figur 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz durch eine Steuereinheit 15 digital steuerbaren Hochfrequenzoszillator 40, der Schwingungen mit einer Frequenz entsprechend der Larmorfrequenz der anzuregenden Atomkerne bei der von den Spulen 1 erzeugten Feldstärke liefert. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung - eine Folge von ein Hüllkurvensignal darstellenden digitalen Datenworten ausgelesen.

Die Mischstufe 43 verarbeitet die ihr zugeführten Eingangssignale so, daß sie an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten Kernresonanzsignale zugeführt werden, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben wwerden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher gespeicherten Datenworte werden einem Rechner 17 zugeführt, der daraus durch eine zweifache diskrete Fouriertransformation das zweidimensionale Spektrum der Kernmagnetisierung ermittelt und an einer geeigneten Wiedergabeeinheit, z.B. ein Monitor 18, ausgibt.

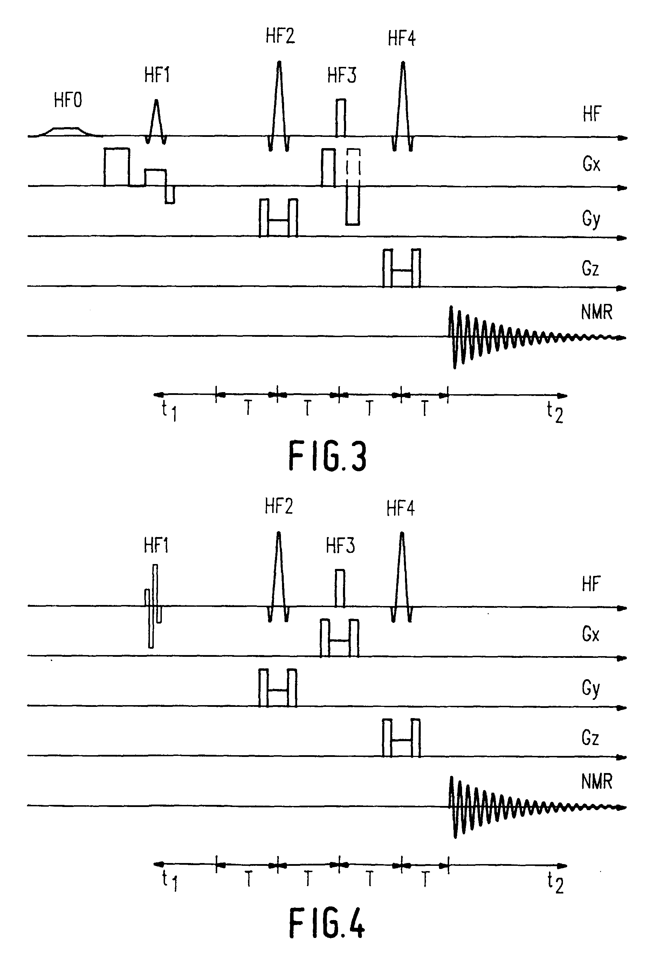

In den Figuren 3 und 4 zeigt jeweils die erste Zeile die zeitliche Lage der vier Hochfrequenzimpulse HF1 .. HF4 der Super COSY-Sequenz. Der erste Impuls HF1 des Hochfrequenzmagnetfeldes, der als Anregungsimpuls bezeichnet wird, ist ein 90°-Impuls. Das gleiche gilt für den dritten Hochfrequenzimpuls HF3, der auch als Kohärenz-Transfer-Impuls bezeichnet wird. Dieser Kohärenz-Transfer-Impuls ist ein "harter", d.h. breitbandiger Impuls, der nicht nur die Kernmagnetisierung der an eine der nachzuweisenden Aminosäuren gebundenen Protonen beeinflußt, sondern auch die Kernmagnetisierung der an Wasser gebundenen Protonen. Der zweite und der vierte Impuls HF2 bzw. HF4 sind 180°-Impulse. Der dritte Hochfrequenzimpuls HF3 befindet sich genau in der Mitte zwischen diesen beiden Impulsen, so daß die drei letzten Impulse einen zeitlichen Abstand T voneinander haben. T kann 1/4J betragen, wobei J die skalare Kopplungskonstante ist (ca. 7 Hz) - kann aber auch, besonders für komplexe Molekülstrukturen, noch kürzer sein.

Der Anfangszeitpunkt der Abtastung des Kernresonanzsignals (5. Zeile von Fig. 3 bzw. Fig. 4) hat von der Mitte des vierten Hochfrequenzimpulses HF4 ebenfalls den Abstand T. Die zeitliche Lage eines Abtastwertes - bezogen auf den erwähnten Abtastzeitpunkt - ist mit $t_2$ bezeichnet. Der zeitliche Abstand des ersten Impulses HF1 vom zweiten Impuls HF2 ist größer als der zeitliche Abstand der drei letzten Impulse HF2..HF4 voneinander und beträgt $t_1$+T. Dieser Abstand wird bei den Wiederholungen der Sequenz variiert. Die einzelnen Abtastwerte der bei diesen Wiederholungen erfaßten Kernresonanzsignale bilden einen zweidimensionalen Datensatz der von den Variablen $t_1$ und $t_2$ abhängt. Eine zweimalige Fouriertransformation hinsichtlich dieser Parameter liefert das gewünschte Frequenzspektrum.

Bei der Ausführungsform der Sequenz nach Fig. 3 geht dem ersten Impuls HF1 noch ein Impuls HF0 voraus, bei dem es sich um einen "weichen" 90°-Impuls handelt, d.h. um einen schmalbandigen, genau auf die Larmorfrequenz der an Wasser gebundenen Protonen abgestimmten Impuls. Dieser regt daher die Kernmagnetisierung der an Wasser gebundenen Protonen an, nicht aber die der an die Aminosäuren gebundenen Protonen. Die auf diese Weise angeregte Kernmagnetisierung wird durch ein magnetisches Gradientenfeld - Gx - dephasiert und hat daher auf das Kernresonanzsignal, das sich nach dem vierten Impuls HF4 entwickelt, praktisch keinen Einfluß.

Der erste (HF1), der zweite (HF2) und der vierte Impuls (HF4) sind bei der Sequenz nach Fig. 3 schichtselektive Impulse, die die Kernmagnetisierung in drei zueinander senkrechten Schichten beeinflussen; der Schnittbereich dieser drei Schichten definiert das Teilvolumen, das spektroskopisch ausgewertet wird. Die Schichtselektion bei HF1, HF2 und HF4 erfolgt dadurch, daß während dieser drei Impulse magnetische Gradientenfelder mit zueinander senkrechten Gradienten - z.B. Gx, Gy, Gz, wirksam sind.

Zusätzlich sind die den Impulsen HF2 und HF4 zugeordneten magnetischen Gradientenfelder vor und nach diesen Impulsen vorzugsweise mit vergrößertem Gradienten wirksam, und zwar so, daß das zeitliche Integral über dieses Gradientenfeld vor dem Impuls genauso groß ist wie nach dem Impuls. Dadurch wird die Kernmagnetisierung in dem außerhalb des selektierten Teilvolumens liegenden Teil des Untersuchungsbereichs noch weiter dephasiert und zusätzlich werden die Komponenten unterdrückt, die dadurch entstehen können, daß HF2 und HF4 in dem selektierten Teilvolumen nicht exakt als 180°-Impulse wirksam sind.

Vor und nach dem dritten Hochfrequenzimpuls wird ebenfalls ein magnetisches Gradientenfeld (Gx) ein- und ausgeschaltet, und zwar mit solchem zeitlichen Verlauf, daß das zeitliche Integral über dieses Gradientenfeld vor dem Impuls dem Betrage nach genauso groß ist wie nach dem Impuls, wobei gemäß der zweiten Zeile von Fig. 3 das Vorzeichen des Gradienten wechselt (ausgezogene Linien in Zeile 2). Bei dem angegebenen zeitlichen Verlauf von HF3 wird die ortsabhängige Dephasierung, welche die durch die Impulse HF1 und HF2 beeinflußte Kernmagnetisierung von dem magnetischen Gradientenfeld vor dem Kohärenztransferimpuls HF3 erfährt, durch die nach HF3 einsetzende Rephasierung kompensiert. Jedoch wirkt dieses Gradientenfeld auf die durch den breitbandigen Kohärenztransferimpuls HF3 erstmals angeregte Kernmagnetisierung - z.B. von Wasser, soweit sie nicht schon durch HF0 vollständig dephasiert ist - dephasierend, weil dieses Gradientenfeld darauf nur nach HF3 einwirken kann.

Zugleich wird durch das Gradientenfeld Gx vor und nach dem Kohärenztransferimpuls HF3 das Spektrum eindeutig gemacht, indem Spiegelungen unterdrückt werden. Ohne diesen Gradienten würde nämlich andernfalls das Spektrum nicht nur peaks auf einer Diagonalen (Diagonalpeaks) und daneben enthalten, sondern auch noch auf einer dazu senkrechten Diagonalen, die die vorgenannte Diagonale im Nullpunkt des Frequenzspektrums schneidet. Das Gradientenfeld Gx vor und nach HF3 unterdrückt also einen dieser "Spiegelungen".

Es ist nicht erforderlich, daß die Gradienten Gx vor und nach dem dritten Hochfrequenzimpuls HF3 das entgegengesetzte Vorzeichen haben; wesentlich ist nur, daß die zeitlichen Integrale über diese Gradienten vor und nach dem Kohärenztransferimpuls HF3 einander gleich sind. Somit können diese Gradienten auch gleiches Vorzeichen haben - wie in Fig. 3 durch Strichelung des auf HF3 folgenden Gradienten angedeutet. Dabei wird lediglich die andere der beiden "Spiegelungen" des zweidimensionalen Frequenzspektrums unterdrückt.

Bei der in Fig. 4 dargestellten bevorzugten Ausführungsform einer Sequenz für die lokalisierte zweidimensionale Protonenspektroskopie sind die drei letzten Impulse HF2...HF4 schichtselektive Impulse, während der erste Impuls HF1 nicht schichtselektiv ist und vorzugsweise ein frequenzselektiver Impuls, dessen Frequenzspektrum bei der Larmorfrequenz der an Wasser gebundenen Protonen verschwindet und bei der Larmorfrequenz der nachzuweisenden Aminosäuren ein Maximum aufweist. Vorzugsweise handelt es sich dabei um einen binomialen ($1\bar{3}3\bar{1}$)-Impuls, der aus vier Teilpulsen besteht, wobei die Frequenz der innerhalb der Teilpulse wirksamen Trägerschwingung und der zeitliche Abstand der Teilpulse entsprechend gewählt sind. Da somit HF1 die Kernmagnetisierung der an Wasser gebundenen Protonen nicht anregt, ist es nicht erforderlich, zur Wasserunterdrückung wie bei der Sequenz nach Fig. 3 einen Hochfrequenzimpuls voranzustellen, der die Kernmagnetisierung dieser Protonen anregt, um diese dann mittels eines Magnetfeldes zu dephasieren.

Der zeitliche Verlauf des magnetischen Gradientenfeldes Gy bzw. Gz vor, während und nach dem zweiten bzw. dem vierten Impuls HF2 bzw. HF4 ist der gleiche wie bei der Sequenz nach Fig. 3. Jedoch ist dabei nicht nur vor und nach dem Impuls HF3 sondern auch während dieses Impulses ein magnetisches Gradientenfeld Gx wirksam, wodurch eine Schicht definiert wird, deren Dicke von der Bandbreite von sowie von der Größe des Gradienten abhängig ist. Die zeitlichen Integrale über den Gradienten vor- und nach dem Impuls HF3 müssen dabei nicht nur gleichen Betrag, sondern auch gleiches Vorzeichen haben; ein entgegengesetztes Vorzeichen dieser Integrale - wie bei der Sequenz nach Fig. 3 - ist nicht möglich.

Wie bereits erwähnt, bewirkt das vor und nach dem Kohärenztransferimpuls HF3 wirksame magnetische Gradientenfeld Gx eine Dephasierung der durch diesen Impuls erstmals angeregten Kernmagnetisierung sowie eine Unterdrückung eines der beiden zueinander spiegelbildlichen Frequenzspektren. Das gleiche Ergebnis kann aber auch -außerhalb des Rahmens der Erfindung- durch das in Verbindung mit dem COSY bzw. Super COSY Verfahren übliche Phasencycling erreicht werden, bei dem - bei sonst gleichen Parametern der Sequenz - die Phasenlage des Kohärenztransferimpulses - bezogen auf die Phasenlage beim ersten Impuls um 90° geändert wird und die Kernresonanzsignale addiert oder subtrahiert werden. Man kann im Rahmen der Erfindung beide Möglichkeiten (Gradientenfeld vor und nach dem Kohärenztransferimpuls und Phasencycling) auch kombiniert benutzen.

**Patentansprüche**

1. Verfahren für die zweidimensionale Kernspinresonanz-Korrelationsspektroskopie mit einer vier Hochfrequenzimpulse (HF1 - HF4) enthaltenden, vielfach wiederholten und zusammen mit einem homogenen stationären Magnetfeld auf einen Untersuchungsbereich einwirkenden Sequenz, die zwei 180°-Impulse enthält, in deren Mitte sich ein dritter, sogenannter Kohärenz-Transfer-Impuls (HF3) befindet und denen ein erster Impuls (HF1) vorangeht, dessen Abstand vom zweiten Impuls (HF2), der gleich oder größer ist als der Abstand der anderen Impulse voneinander, bei der Wiederholung der Sequenz variiert wird, dadurch gekennzeichnet, daß während drei der vier Impulse magnetische Gradientenfelder wirksam sind, deren Gradienten zueinander senkrecht verlaufen, und daß vor und nach dem dritten Hochfrequenzimpuls (HF3) ein magnetisches Gradientenfeld (Gx) mit solcher Dauer und solchem Gradienten wirksam ist, daß das zeitliche Integral über diesen Gradienten vor dem dritten Impuls dem Betrage nach die gleiche Größe hat wie nach dem dritten Impuls.

2. Verfahren nach Anspruch 1, dadurch gekennzeichnet, daß der erste Hochfrequenzimpuls (HF1) ein frequenzselektiver, nicht von einem Gradientenfeld begleiteter Impuls ist, der die Kernmagnetisierung der an Wasser gebundenen Protonen nicht anregt, jedoch die Kernmagnetisierung der an die nachzuweisenden Verbindungen gebundenen Protonen, und daß vor, während und nach dem dritten Hochfrequenzimpuls (HF3) wenigstens ein magnetisches Gradientenfeld (Gx) mit solchem Gradienten und solcher Dauer wirksam ist, daß das zeitliche Integral über diesen Gradienten in dem in der Mitte des dritten Impulses endenden Zeitintervall genauso groß ist wie in dem in der Mitte des dritten Impulses beginnenden Zeitintervall.

3. Verfahren nach Anspruch 1, dadurch gekennzeichnet, daß der erste Hochfrequenzimpuls (HF1) von einem magnetischen Gradientenfeld begleitet ist, daß diesem Impuls ein frequenzselektiver, nur die Kernmagnetisierung von an Wasser gebundenen Protonen anregender Impuls (HF0) vorangeht, wonach vor dem ersten Impuls zwecks Dephasierung ein magnetisches Gradientenfeld Gx) ein- und ausgeschaltet wird und daß während des dritten Impulses (HF3) ein magnetisches Gradientenfeld eingeschaltet wird.

4. Verfahren nach einem der Ansprüche 1 bis 3, dadurch gekennzeichnet, daß vor und nach den beiden 180°-Hochfrequenzimpulsen jeweils ein magnetisches Gradientenfeld mit solchem Gradienten und solcher Dauer wirksam ist, daß das zeitliche Integral über dieses Feld vor und nach den betreffenden Impulsen jeweils gleich groß ist.

5. Kernspinresonanz-Anordnung mit Mitteln (1) zur Erzeugung eines homogenen, stationären Magnetfeldes, mit einer Hochfrequenzspulenanordnung (11) zum Erzeugen von Hochfrequenzimpulsen und zum Aufnehmen der als Reaktion darauf im Untersuchungsbereich erzeugten Kernspinresonanzsignale, mit einer Verarbeitungseinheit (17) zum Erzeugen eines Spektrums aus den aufgenommenen Kernspinresonanzsignalen, mit einer Gradientenspulenanordnung (3, 5, 7) zur Erzeugung magnetischer Gradientenfelder und mit einer Steuereinheit (15) zum Steuern der Hochfrequenzspulenanordnung und der Gradientenspulenanordnung, wobei die Steuereinheit (15) zum Erzeugen der Zweidimensionalen Kernspinresonanzsequenz gemäß dem Oberbegriff von Anspruch 1 ausgebildet ist, dadurch gekennzeichnet, daß die Steuereinheit (15) zur Durchführung des Verfahrens nach Anspruch 1 so ausgebildet ist, daß sie während drei der vier Hochfrequenzimpulse der Sequenz magnetische Gradientenfelder erzeugt, deren Gradienten zueinander senkrecht verlaufen, und daß vor und nach dem dritten Hochfrequenzimpuls ein magnetisches Gradientenfeld mit solcher Dauer und solchem Gradienten wirksam wird, daß das zeitliche Integral über dieses Feld vor dem dritten Impuls dem Betrage nach die gleiche Größe hat wie nach dem dritten Impuls.

**Claims**

1. A method for two-dimensional magnetic resonance correlation spectroscopy with a frequently repeated sequence of four high-frequency pulses (HF1-HF4) which acts, together with a homogeneous stationary magnetic field, upon an examination area, which sequence contains two 180° pulses, halfway between which a third, so-called coherence transfer pulse (HF3) is located and is preceded by a first pulse (HF1) whose distance from the second pulse (HF2) which is equal to or larger than the distance between the other pulses, is varied during the repetition of the sequence, characterized in that magnetic gradient fields are operative during three of the four pulses, their gradients extending mutually perpendicularly, and that before and after the third high-frequency pulse (HF3) there is operative a magnetic gradient field (Gx) having a duration and a gradient such that the time integral over these gradients before the third pulse has the same absolute value as after the third pulse.

2. A method as claimed in Claim 1, <u>characterized in that</u> the first high-frequency pulse (HF1) is a frequency-selective pulse which is not accompanied by a gradient field and does not excite the nuclear magnetization of the water-bound protons but excites the nuclear magnetization of the protons bound to the compounds to be detected and that before, during and after the third high-frequency pulse (HF3) at least one magnetic gradient field (Gx) is operative with such a gradient and duration that terminating at the centre of the third pulse the time integral over this gradient is exactly equal to that in the time interval beginning at the centre of the third pulse.

3. A method as claimed in Claim 1, <u>characterized in that</u> the first high-frequency pulse (HF1) is accompanied by a magnetic gradient field, that this pulse is preceded by a frequency-selective pulse (HFO) which excites only the nuclear magnetization water-bound of protons, after which before the first pulse a magnetic gradient field (Gx) is switched on and off for dephasing purposes, and that during the third pulse (HF3) a magnetic gradient field is switched on.

4. A method as claimed in any one of Claims 1 to 3, <u>characterized in that</u> before and after the two 180° high-frequency pulses a magnetic respective gradient field is operative with a gradient and a duration such that the time integral over this field is the same before and after the relevant pulses.

5. A magnetic resonance arrangement, comprising means (1) for generating a homogeneous, stationary magnetic field, a high-frequency coil system (11) for generating high-frequency pulses and for detecting the spin resonance signals produced in response thereto in the examination area, a processing unit for generating a spectrum from the detected spin resonance signals, a gradient coil system (3, 5, 7) for generating magnetic gradient fields and a control unit (15) for controlling the high-frequency coil system and the gradient coil system, the control unti (15) being constructed so as to produce the two-dimensional spin resonance sequence in conformity with the introductory part of Claim 1, <u>characterized in that</u> the control unit (15) for carrying out the method of Claim 1 is constructed so that during three of the four high-frequency pulses of the sequence it generates magnetic gradient fields whose gradients extend perpendicularly to one another, and that before and after the third high-frequency pulse a magnetic gradient field becomes operative which has a duration and a gradient such that the absolute value of the time integral over this field is the same before and after the third pulse.

## Revendications

1. Procédé pour la spectroscopie bidimensionnelle de corrélation à résonance par spin nucléaire avec une séquence contenant quatre impulsions à haute fréquence (HF1-HF4), répétée à plusieurs reprises et agissant en même temps qu'un champ magnétique stationnaire homogène sur une région à examiner, laquelle séquence contient deux impulsions à 180° au milieu desquelles se trouve une troisième impulsion HF3, dite impulsion de transfert de cohérence, et qui sont précédées par une première impulsion (HF1) dont la distance par rapport à la deuxième impulsion (HF2) qui est égale ou supérieure à la distance des autres impulsions entre elles, varie en cas de répétition de la séquence, caractérisé en ce que, pendant trois des quatre impulsions, sont actifs des champs de gradients magnétiques dont les gradients s'étendent perpendiculairement l'un à l'autre et en ce qu'avant et après la troisième impulsion à haute fréquence (HF3), agit un champ de gradient magnétique (Gx) d'une durée et d'un gradient tels que l'intégrale temporelle sur ce gradient avant la troisième impulsion a la même longueur par module qu'après la troisième impulsion.

2. Procédé selon la revendication 1, caractérisé en ce que la première impulsion à haute fréquence (HF1) est une impulsion sélective de fréquence non accompagnée par un champ de gradient qui n'excite pas la magnétisation nucléaire des protons liés à l'eau, mais la magnétisation nucléaire des protons liés aux composés à détecter et en ce qu'avant, pendant et après la troisième impulsion à haute fréquence (HF3), au moins un champ de gradient magnétique (Gx) est actif avec un gradient et une durée tels que l'intégrale temporelle sur ce gradient est aussi grande dans intervalle de temps se terminant au milieu de la troisième impulsion que dans l'intervalle de temps commençant au milieu de la troisième impulsion.

3. Procédé selon la revendication 1, caractérisé en ce que la première impulsion à haute fréquence (HF1) est accompagnée par un champ de gradient magnétique, en ce que cette impulsion est précédée par une impulsion (HF0) sélective de fréquence excitant seulement la magnétisation nucléaire des protons liés à l'eau, après quoi un champ de gradient magnétique (Gx) est mis en service ou hors service avant la première impulsion en vue du déphasage et en ce que, pendant la troisième impulsion (HF3), un champ de gradient magnétique est mis en service.

4.  Procédé selon l'une des revendications 1 à 3, caractérisé en ce qu'avant et après les deux impulsions à haute fréquence à 180°, agit respectivement un champ de gradient magnétique avec un gradient et une durée tels que l'intégrale temporelle sur ce champ est d'égale grandeur avant et après les impulsions correspondantes.

5.  Dispositif de résonance par spin nucléaire avec des moyens (1) pour la production d'un champ magnétique stationnaire homogène avec un dispositif à bobines à haute fréquence (11) pour la production d'impulsions à haute fréquence et pour l'enregistrement des signaux de résonance par spin nucléaire produits dans la région à examiner en réaction, avec une unité de traitement (17) pour la production d'un spectre à partir des signaux de résonance par spin nucléaire enregistrés, avec un dispositif à bobines de gradients (3, 5, 7) pour la production de champs de gradients magnétiques et avec une unité de commande (15) pour la commande du dispositif à bobines à haute fréquence et du dispositif à bobines de gradients, l'unité de commande (15) étant conçue pour la production de la séquence de résonance par spin nucléaire bidimensionnelle selon le préambule de la revendication 1, caractérisé en ce que l'unité de commande en vue de l'exécution du procédé selon la revendication 1 est conçue de telle sorte qu'elle produit pendant trois des quatre impulsions à haute fréquence de la séquence des champs de gradients magnétiques dont les gradients sont perpendiculaires l'un à l'autre et en ce qu'avant et après la troisième impulsion à haute fréquence, est actif un champ de gradient magnétique d'une durée et d'un gradient tels que l'intégrale temporelle sur ce champ a la même grandeur par module avant la troisième impulsion qu'après la troisième impulsion.

FIG.1

FIG.2

FIG.3

FIG.4